# FASCICULE DE BREVET EUROPEEN

(11) **EP 1 120 659 B1**
(45) Date de publication et mention de la délivrance du brevet: **30.06.2004**
(21) Numéro de dépôt: 01440012.1
(22) Date de dépôt: 24.01.2001
(51) Int. Cl.: G01R 11/04

(54) **Compteur d'énergie électrique**
Elektrischer Energiezähler
Electrical energy meter

(30) Priorité: 28.01.2000 FR 0001091
(43) Date de publication de la demande: 01.08.2001
(73) Titulaire: Socomec S.A., 67230 Benfeld (FR)
(72) Inventeur: Krumenacker, Michel, 67150 Matzenheim (FR); Olhagaray, Laurent, 67000 Strasbourg (FR)
(74) Mandataire: Nithardt, Roland

(56) Documents cités:
- WO-A-94/27157
- US-A- 5 420 799

## Description

La présente invention concerne un compteur d'énergie électrique comportant un boîtier, au moins une borne d'entrée et une borne de sortie aptes à recevoir un câble électrique d'un réseau de distribution, chaque borne étant pourvue d'un organe de serrage dudit câble, ledit boîtier étant agencé pour définir un passage de câble rectiligne s'étendant entre les deux bornes, ce compteur d'énergie comportant aussi un transformateur d'intensité disposé autour dudit passage de câble, une prise de tension prévue sur l'une desdites bornes et un circuit électronique connecté audit transformateur d'intensité et à ladite prise de tension agencé pour traiter les informations qu'ils mesurent.

Ce type de compteur d'énergie est bien connu et utilisé dans toutes les applications de comptage du courant, par exemple dans les applications domestiques ou dans les réseaux industriels associé par exemple à des systèmes de supervision dudit réseau. La mesure de courant est effectuée communément par un transformateur d'intensité qui se présente sous la forme d'un tore au travers duquel passe le conducteur électrique, le câble ou la barre conductrice. On comprend aisément que ce montage n'est pas toujours possible en fonction notamment de la longueur des câbles.

Les fabricants de compteurs d'énergie ont donc conçu deux types d'appareil : un compteur pour câble traversant et un compteur pour câble non traversant. Dans ce dernier cas, le compteur est équipé sur chaque phase d'un conducteur intérieur fixe qui assure un pontage entre les bornes d'entrée et de sortie correspondantes, ce pontage traversant ledit transformateur d'intensité. Le fait de proposer deux appareils différents pour la même application coûte cher aux fabricants qui doivent doubler leur production, leur stockage et leur référence pour chaque gamme d'intensité.

L'idée de pouvoir utiliser un compteur d'énergie pour câble non traversant en compteur d'énergie pour câble traversant n'est pas envisageable car les bornes de connexion ont des sections normalisées qui correspondent aux sections des câbles, barres ou conducteurs. Les bornes sont, par conséquent, trop étroites pour y loger à la fois le câble traversant et le pontage intérieur.

Par ailleurs, il existe deux variantes d'application selon que le compteur d'énergie est utilisé en version modulaire, c'est-à-dire monté sur un rail normalisé d'un châssis de câblage dans une armoire électrique, ou en version encastrée, c'est-à-dire monté directement sur une porte d'armoire électrique, l'écran du compteur étant généralement visible de l'extérieur de l'armoire. Pour ces deux versions, les fabricants de compteurs ont également prévu deux références différentes de compteur car le dispositif de montage est différent selon les applications. Ceci impose encore de doubler les références de compteur disponibles auprès des fabricants.

US 5 420 799 divulgue un compteur d'énergie électrique comportant un tunnel isolé et formant un passage de câble.

WO 94/27/57 décrit une lame métallique de faible épaisseur s'étendant entre les bornes d'entrée et de sortie d'un compteur d'énergie.

Le but de l'invention est de pallier ces inconvénients en proposant un compteur d'énergie électrique unique pouvant être utilisé aussi bien pour câble traversant que pour câble non traversant, pouvant être monté aussi bien en version modulaire qu'en version encastrée, tout en respectant les normes relatives aux sections des bornes de connexion en fonction de la section des câbles.

Ce but est atteint par un compteur d'énergie tel que les bornes d'entrée et de sortie présentent dans au moins une de leurs parois un évidement en regard de l'organe de serrage, ledit compteur d'énergie comportant tunnel isolé électriquement s'étendant entre les deux bornes et formant ledit passage de câble rectiligne et ce compteur comportant également une pièce électriquement conductrice disposée à demeure à l'intérieur dudit tunnel et s'étendant entre les bornes d'entrée et de sortie pour les relier électriquement formant un pontage, ladite pièce conductrice étant formée d'une lame métallique de faible épaisseur et de section complémentaire à celle dudit évidement prévu dans lesdites bornes.

Dans une forme de réalisation préférée de l'invention, le tunnel est constitué de deux demi-tunnels emboîtés coaxialement et agencés pour former un passage de câble continu et rectiligne, 7 ces demi-tunnels présentant un diamètre extérieur correspondant au diamètre intérieur dudit transformateur d'intensité.

Les bornes d'entrée et de sortie comportent, avantageusement, une bride intérieure métallique, disposée coaxialement audit tunnel et dont au moins une paroi comporte ledit évidement, cette bride intérieure étant logée dans un corps de borne formé de deux parties emboîtées.

L'organe de serrage peut comporter une vis de serrage montée dans la bride intérieure perpendiculairement à l'axe du passage de câble, et un cavalier plat interposé entre l'extrémité de la vis de serrage et le câble électrique logé dans ladite borne.

La prise de tension peut comporter une vis pointeau montée dans la bride intérieure perpendiculairement à l'axe du passage de câble et agencée pour réaliser un contact électrique avec ledit câble électrique logé dans ladite borne après son serrage.

Dans la forme de réalisation préférée, le circuit électronique comporte au moins un circuit imprimé fixé directement sur ledit tunnel au moyen de pattes de fixation prévues à l'extérieur dudit tunnel.

Ce circuit imprimé peut, si besoin, être agencé pour recevoir un transformateur de tension assurant un isolement galvanique.

Dans la forme de réalisation préférée, le boîtier comporte plusieurs parties assemblées par emboîtement dont au moins un socle et un capot, le socle comportant une rainure agencée pour recevoir un rail de montage normalisé prévu sur un châssis de câblage électrique et le capot comportant des trous de fixation agencés pour permettre le montage dudit compteur sur une porte d'armoire électrique.

Ce compteur d'énergie comporte, avantageusement, un nombre de bornes d'entrée et de sortie, de tunnels, de transformateurs d'intensité et de prises de tension égal au nombre de phases dudit réseau de distribution, les transformateurs d'intensité étant disposés en quinconce et les circuits électroniques étant répartis sur deux plaques de circuit imprimé parallèles montées de part et d'autre des tunnels, ce qui permet de réaliser un module compact.

A cet effet, les plaques de circuits imprimés comportent en regard des transformateurs d'intensité des découpes correspondantes laissant traverser partiellement lesdits transformateurs afin de limiter l'encombrement.

La présente invention et ses avantages seront mieux compris dans la description suivante d'une forme de réalisation donnée à titre d'exemple non limitatif et en référence aux dessins annexés, dans lesquels :

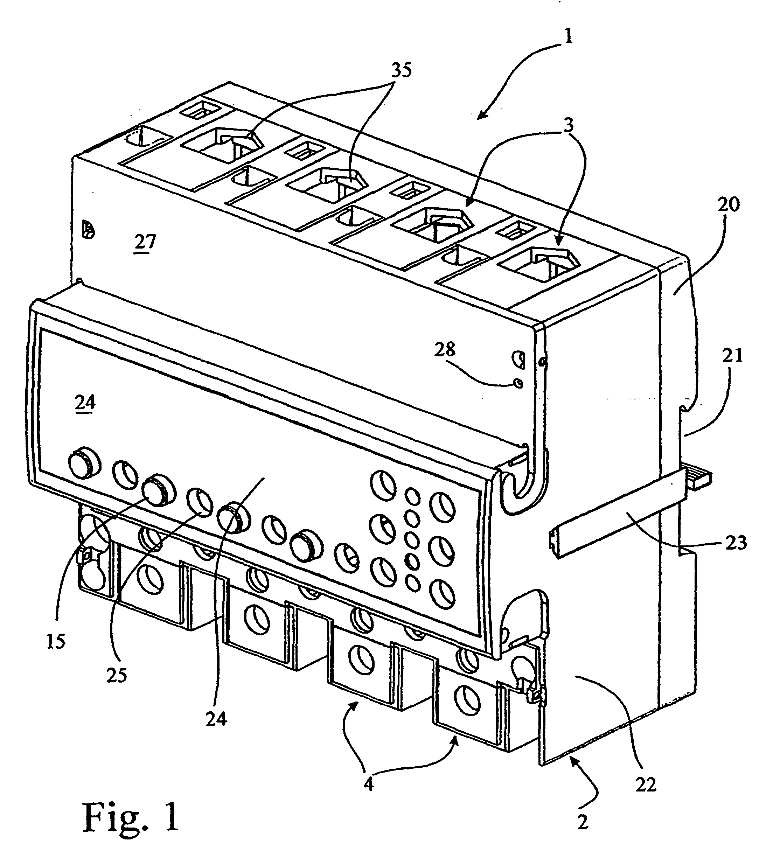

- la figure 1 représente le compteur d'énergie selon l'invention, vue de face en perspective,
- les figures 2 et 3 sont des vues en coupe longitudinale du compteur de la figure 1, correspondant à deux modes d'utilisation,

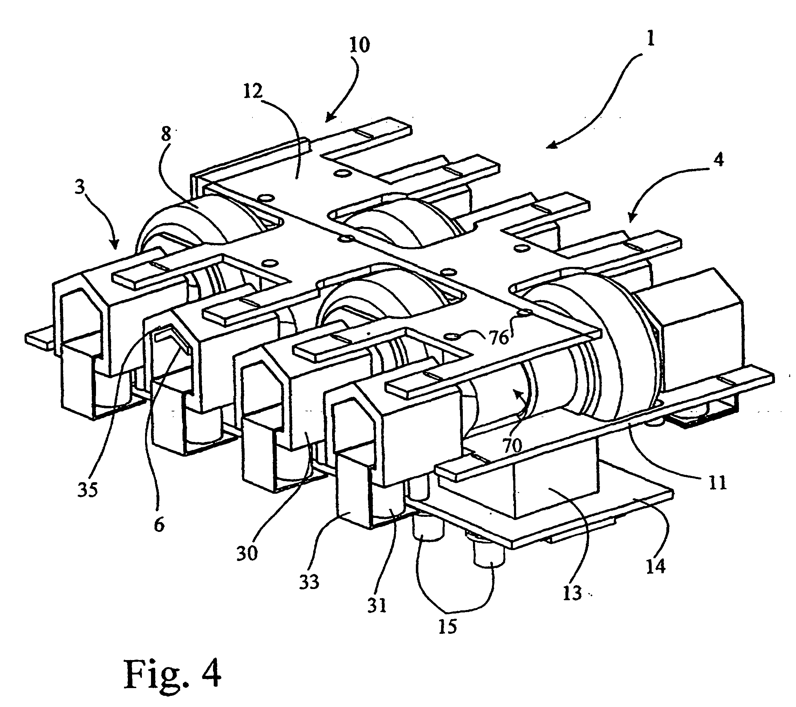

- la figure 4 est une vue de dessous en perspective de l'intérieur du compteur de la figure 1,
- la figure 5 est une vue en coupe transversale du compteur de la figure 1, et
- la figure 6 est une vue de dessus en perspective du compteur de la figure 1 sans le boîtier.

En référence aux figures, le compteur d'énergie électrique 1 selon l'invention comporte un boîtier 2, au moins une borne d'entrée 3 et une borne de sortie 4 alignées, aptes à recevoir un câble électrique 5.5' d'un réseau de distribution. Dans l'exemple illustré, le compteur 1 comporte quatre paires de bornes 3, 4 et est destiné à être utilisé sur un réseau de distribution tétraphasé alimenté par trois conducteurs de phase et un conducteur de neutre.

Ce compteur 1 comporte à l'intérieur de son boîtier 2 quatre passages de câble 7 rectilignes s'étendant entre les paires de bornes 3, 4, un transformateur d'intensité 8 constitué d'un tore disposé autour de chaque passage de câble 7, une prise-de tension 9 prévue sur chaque borne d'entrée ou de sortie, et un circuit électronique 10 connecté aux transformateurs d'intensité 8 et aux prises de tension 9 agencé pour traiter les informations qu'ils mesurent.

Chaque passage de câble 7 est délimité par un tunnel 70 isolé électriquement et s'étendant entre deux bornes 3 et 4 correspondantes. Pour des questions de montage, ce tunnel 70 est constitué de deux demi-tunnels 71, 72 emboîtés coaxialement et agencés pour former un passage de câble 7 continu et rectiligne. Ils sont, par exemple, réalisés en matière synthétique moulée et comportent des formes complémentaires d'emboîtement. Dans la zone d'emboîtement A, le demi-tunnel 71 comporte un diamètre intérieur correspondant au diamètre extérieur du demi-tunnel 72. Le demi-tunnel 72 reçoit sur son diamètre extérieur un transformateur d'intensité 8, ce dernier étant arrêté en translation axiale, du côté de la zone d'emboîtement A, par l'extrémité 73 du demi-tunnel 71 et, de l'autre côté, par une butée radiale 74 prévue sur le demi-tunnel 72.

Chaque borne d'entrée 3 ou de sortie 4 comporte une bride intérieure métallique 30, disposée coaxialement audit tunnel 70 et agencée pour recevoir ledit câble électrique 5, 5', sa section étant adaptée à celle dudit câble. Ce câble 5, 5' est bloqué à l'intérieur de la bride 30 au moyen d'un organe de serrage constitué d'une vis de serrage 31 vissée dans un trou fileté 32 prévu dans la bride 30 perpendiculairement à l'axe du passage de câble 7. Un cavalier plat 33 est interposé entre l'extrémité de la vis de serrage 31 et le câble électrique 5,5' pour augmenter la surface de serrage et fiabiliser ledit serrage.

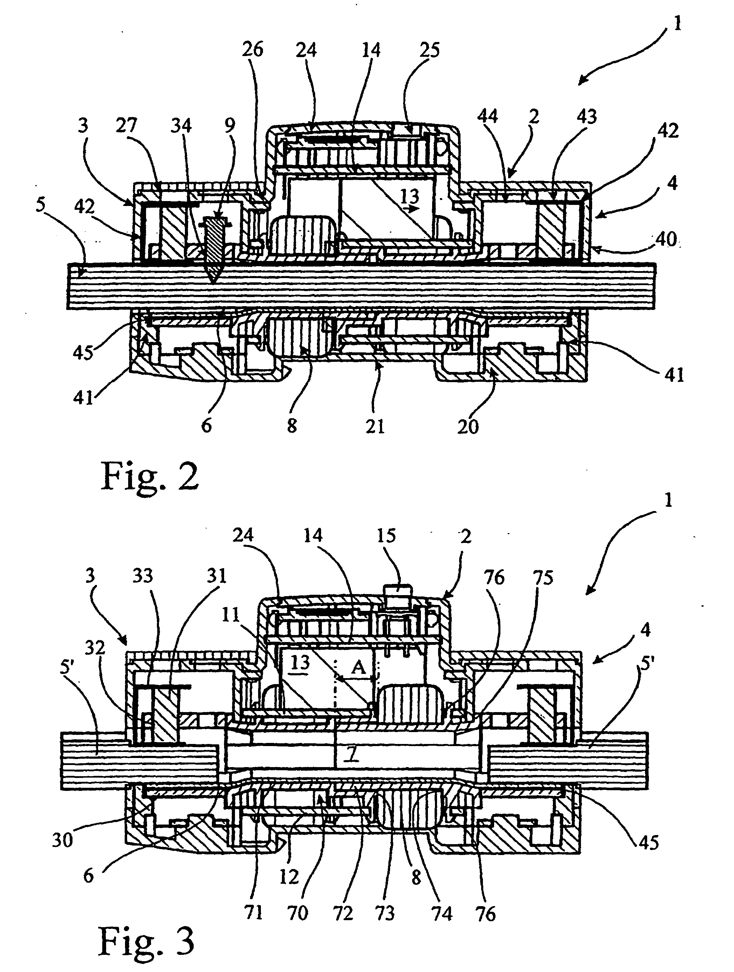

Sur chaque borne d'entrée 3 (cf. Fig. 2) est prévue la prise de tension 9 formée d'une vis pointeau vissée dans un trou fileté 34 ménagé dans la bride 30 perpendiculairement à l'axe du passage de câble 7. Cette vis pointeau 9 permet de réaliser un contact électrique avec le câble électrique 5, 5' logé dans ladite borne 3, le cas échéant, en perforant l'isolant qui entoure ledit câble.

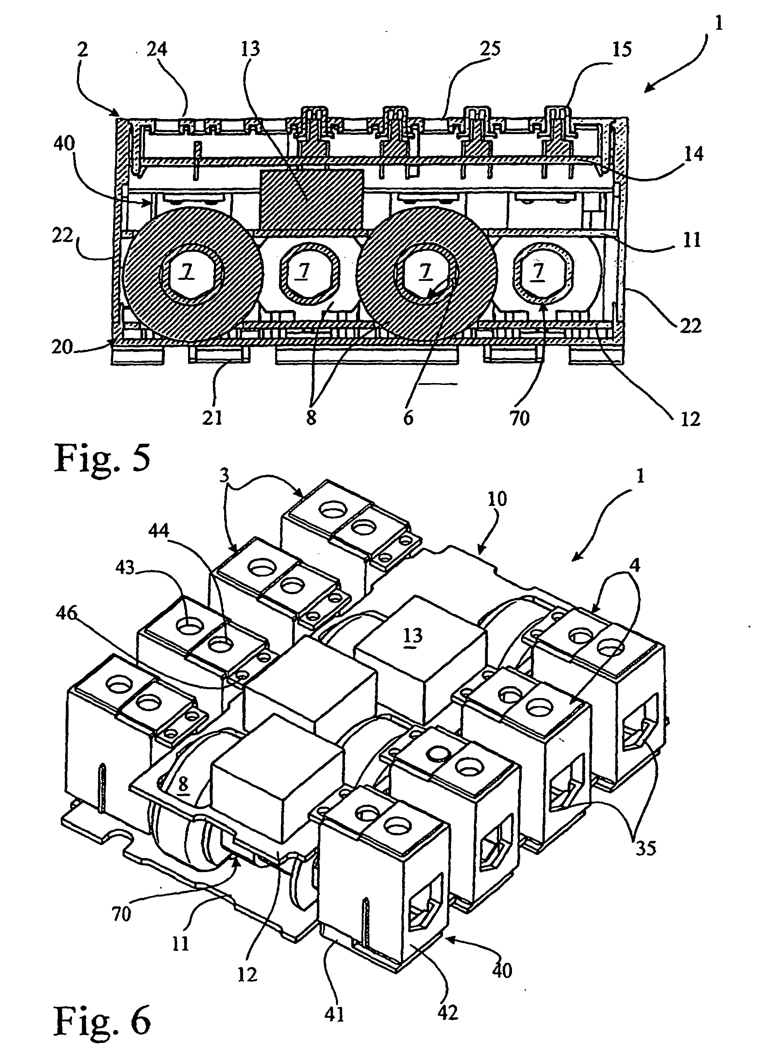

L'originalité du compteur d'énergie 1, selon l'invention, réside dans le fait qu'il comporte, dans chaque tunnel 70, une pièce 6 électriquement conductrice s'étendant entre les bornes d'entrée 3 et de sortie 4 pour les relier électriquement et former un pontage. Elle est logée à demeure dans un évidement 35 prévu au moins dans les brides 30 desdites bornes 3 et 4, en regard de la vis de serrage 31. A cet effet, cette pièce conductrice 6 est constituée d'une lame métallique de faible épaisseur et de section complémentaire à celle dudit évidement 35. Ainsi, cette pièce conductrice 6 est disposée de manière à ne pas réduire la section de passage de câble 7 à l'intérieur des brides 30, ni à l'intérieur du tunnel 70 qui a une section légèrement ovale (cf. fig. 5).

Comme représenté dans les figures, l'évidement 35 est ménagé dans la paroi inférieure des brides 30 et présente une forme en V. Il pourrait avoir des formes variées, l'essentiel étant que la section de passage de câble ne soit pas amputée par la pièce conductrice 6.

Ainsi, grâce à cette construction et comme on le voit clairement dans les figures 2 et 3, le compteur d'énergie 1 peut être utilisé aussi bien avec un câble traversant 5 (cf. Fig. 2) qu'avec un câble non traversant 5' (cf. Fig. 3). Dans l'application illustrée par la figure 2, cette pièce conductrice 6 n'a aucune fonction alors que dans l'application illustrée par la figure 3, elle permet d'assurer la continuité du courant et de remplacer le câble inexistant entre les deux bornes d'entrée 3 et de sortie 4.

Le but principal de l'invention est atteint. Néanmoins, ce compteur d'énergie 1 combine des astuces constructives qui le rendent beaucoup plus compact, donc de dimensions réduites, et adaptables à un montage en version modulaire ou en version encastrée, comme cela est à présent expliqué.

Pour des questions de montage, les bornes d'entrée 3 et de sortie 4 comportent un corps de borne 40 réalisé en deux parties 41 et 42 emboîtées, une partie inférieure 41 et une partie supérieure 42. Il s'agit de pièces réalisées en matière synthétique moulée et pourvues de formes complémentaires dans leur zone d'emboîtement. Le corps de borne 40 forme une enveloppe isolante autour de la bride métallique 30 et comporte, dans sa partie supérieure 42, deux orifices 43 et 44 disposés au droit de la vis de serrage 31 et de la vis pointeau 9 de prise de tension, permettant l'accès d'un outil tel qu'un tournevis. Ce corps de borne 40 assure également une liaison mécanique avec le tunnel 70. A cet effet, l'extrémité correspondante des demi-tunnels 71 et 72 est légèrement évasée et se termine par un bourrelet périphérique 75 à l'arrière duquel vient en butée axiale la base de la partie supérieure 42. Ce corps de borne 40 assure aussi le blocage axial de la pièce conductrice 6 au moyen d'un épaulement 45 prévu dans la partie inférieure 41.

Le circuit électronique 10 prévu à l'intérieur du compteur d'énergie 1 est prévu sur deux plaques de circuit imprimé 11 et 12 disposées parallèlement et fixées directement de part et d'autre du tunnel 70 au moyen de pattes de fixation 76 prévues à l'extérieur dudit tunnel. Ces deux plaques 11 et 12 sont découpées pour pouvoir se loger entre les transformateurs d'intensité 8, ces derniers étant disposés en quinconce pour réduire la largeur de l'ensemble. Des transformateurs de tension 13 peuvent être disposés sur des plaques si un isolement galvanique est requis. Une platine 14 est prévue dans la partie médiane du compteur d'énergie 1 pour supporter les différents boutons de commande 15, des diodes luminescentes, etc.

L'ensemble formé par toutes les-pièces intérieures est capoté par le boîtier 2 constitué au moins d'un socle 20 et d'un capot 22 assemblés par emboîtement et fixés par des vis ou des rivets ou tout autre moyen de fixation.

Le socle 20, qui sert de support, présente des formes intérieures agencées pour recevoir les pièces intérieures correspondantes, telles que la partie inférieure 41 du corps de borne 40 et les transformateurs d'intensité 8. Extérieurement, ce socle 20 est sensiblement plan et comporte dans sa partie médiane une rainure 21 apte à recevoir un rail de fixation normalisé DIN prévu généralement sur les châssis de câblage électrique, permettant ainsi le montage dudit compteur 1 en version modulaire.

Le capot 22, qui vient recouvrir l'ensemble des pièces intérieures, comporte une partie frontale saillante 24 se superposant à la platine 14 et dans laquelle sont ménagés des orifices 25 destinés à recevoir les boutons de commande 15. Cette partie frontale saillante 24 présente une section sensiblement en oméga dont les pattes 26 sont fixées aux parties supérieures 42 des corps de borne 40 au moyen de vis de fixation dans des orifices 46. Ce capot 22 comporte des couvercles de sécurité 27 disposés sur les parties frontales des bornes d'entrée 3 et de sortie 4 qui sont en retrait par rapport à la partie frontale saillante 24. Ces couvercles de sécurité 27 sont, par exemple, plombés et réalisés en polycarbonate transparent. Ce capot 22 comporte des trous de fixation 28 prévus dans les couvercles de sécurité 27 et permettant ainsi la fixation dudit compteur d'énergie 1 à l'arrière d'une porte d'armoire électrique en version encastrée. Dans ce cas, la porte comporte une découpe rectangulaire apte à recevoir la partie frontale saillante 24 dudit compteur.

Le capot 22 comporte encore sur ses côtés un rail 23 et une rainure de forme correspondante permettant l'assemblage côte à côte d'au moins deux compteurs d'énergie 1 similaires.

Le compteur d'énergie 1 tel que décrit ci-dessus peut être réalisé à moindre coût, la majorité des pièces étant moulées en matière synthétique. Il peut être assemblé et monté rapidement car toutes les pièces ou parties de pièce sont conçues pour s'emboîter facilement les unes dans les autres, certaines assurant simultanément le maintien mécanique d'autres pièces. Il est bien entendu équipé des pièces conductrices 6 montées à demeure à l'intérieur de chaque tunnel 70 et s'étendant d'une borne d'entrée 3 à une borne de sortie 4, solidement logées dans l'évidement 35 et bloquées en translation axiale par le corps de borne 40. A cet effet, la pièce conductrice 6 est profilée pour suivre sensiblement le profil défini par le tunnel 70 et les évidements 35, comportant notamment deux changements de niveau. Ce profil contribue également à éviter un déplacement axial involontaire de cette pièce conductrice 6, notamment lors de la mise en place d'un câble traversant 5.

Le compteur d'énergie 1 tel qu'obtenu est d'encombrement réduit grâce au mode de réalisation et de positionnement des différentes pièces les unes par rapport aux autres. Pour être utilisé, il suffit de le positionner sur un rail DIN d'un châssis de câblage dans une armoire électrique ou de le monter à l'arrière d'une porte d'armoire électrique, respectivement au moyen de sa rainure 21 ou de ses trous de fixation 28 correspondants. Pour le câbler, deux solutions sont possibles :
1. si le câble 5 est traversant, il suffit de le faire passer de part en part à travers les bornes d'entrée 3 et de sortie 4 correspondantes et le tunnel 70, de bloquer les vis de serrage 31 pour assurer la liaison mécanique et de serrer la vis pointeau 9 pour assurer la mesure de tension en perforant l'isolant qui entoure ledit câble, la mesure de l'intensité par le transformateur d'intensité 8 étant également assurée,
2. si le câble 5' n'est pas traversant, il suffit de dénuder les extrémités dudit câble, de les introduire dans les bornes d'entrée 3 et de sortie 4 correspondantes et de bloquer les vis de serrage 31 pour assurer la liaison mécanique, la mesure de tension étant dans ce cas assurée par la bride 30 elle-même. Dans ce cas, la continuité électrique est assurée par la pièce conductrice 6 en contact avec les extrémités dénudées dudit câble 5' et la mesure de l'intensité par le transformateur d'intensité 8 est ainsi assurée.

Il ressort clairement de cette description que l'invention permet d'atteindre tous les buts fixés. En résumé, le compteur d'énergie 1 selon l'invention permet de remplacer à lui seul quatre compteurs de types différents. Ceci permet de réduire nettement les coûts de production et de gestion, et de simplifier le travail des installateurs électriques.

## Revendications

1. Compteur d'énergie électrique (1) comportant un boîtier (2), au moins une borne d'entrée (3) et une borne de sortie (4) alignées, aptes à recevoir un câble électrique (5, 5) d'un réseau de distribution, chaque borne (3, 4) étant pourvue d'un organe de serrage (31) dudit câble, ledit boîtier (2) étant agencé pour définir un passage de câble (7) rectiligne s'étendant entre les deux bornes, ce compteur d'énergie comportant aussi un transformateur d'intensité (8) disposé autour dudit passage de câble (7), une prise de tension (9) prévue sur l'une desdites bornes et un circuit électronique (10) connecté audit transformateur d'intensité et à ladite prise de tension agencé pour traiter les informations qu'ils mesurent, ledit compteur d'énergie comportant un tunnel (70) isolé électriquement s'étendant entre les deux bornes et formant ledit passage de câble (7) rectiligne, **caractérisé en ce que** les bornes d'entrée (3) et de sortie (4) présentent dans au moins une de leurs parois un évidement (35) en regard de l'organe de serrage (31) et **en ce que** ce compteur comporte une pièce (6) électriquement conductrice disposée à demeure à l'intérieur dudit tunnel (70) et s'étendant entre les bornes d'entrée (3) et de sortie (4) pour les relier électriquement formant un pontage, ladite pièce conductrice (6) étant formée d'une lame métallique de faible épaisseur et de section complémentaire à celle dudit évidement (35) prévu dans lesdites bornes.

2. Compteur d'énergie selon la revendication 1, **caractérisé en ce que** le tunnel (70) est constitué de deux demi-tunnels (71, 72) emboîtés coaxialement et agencés pour former un passage de câble (7) continu et rectiligne, ces demi-tunnels présentant un diamètre extérieur correspondant au diamètre intérieur dudit transformateur d'intensité (8).

3. Compteur d'énergie selon la revendication 1, **caractérisé en ce que** les bornes d'entrée (3) et de sortie (4) comportent une bride (30) intérieure métallique, disposée coaxialement audit tunnel (70) et dont au moins une paroi comporte ledit évidement (35), cette bride (30) intérieure étant logée dans un corps de borne (40) formé de deux parties (41, 42) emboîtées.

4. Compteur d'énergie selon la revendication 3, **caractérisé en ce que** l'organe de serrage comporte une vis de serrage (31) montée dans la bride (30) intérieure perpendiculairement à l'axe du passage de câble (7), et un cavalier plat (33) interposé entre l'extrémité de la vis de serrage (31) et le câble électrique (5, 5) logé dans ladite borne (3, 4).

5. Compteur d'énergie selon la revendication 3, **caractérisé en ce que** la prise de tension comporte une vis pointeau (9) montée dans la bride (30) intérieure perpendiculairement à l'axe du passage de câble (7) et agencée pour réaliser un contact électrique avec ledit câble électrique (5,5') logé dans ladite borne (3, 4) après son serrage.

6. Compteur d'énergie selon la revendication 1, **caractérisé en ce que** le circuit électronique (10) comporte au moins un circuit imprimé (11, 12) fixé directement sur ledit tunnel (70) au moyen de pattes de fixation (76) prévues à l'extérieur dudit tunnel.

7. Compteur d'énergie selon la revendication 6, **caractérisé en ce que** ledit circuit imprimé (11, 12) est agencé pour recevoir un transformateur de tension (13) assurant un isolement galvanique.

8. Compteur d'énergie selon la revendication 1, **caractérisé en ce que** le boîtier (2) comporte plusieurs parties assemblées par emboîtement dont au moins un socle (20) et un capot (22), le socle (20) comportant une rainure (21) agencée pour recevoir un rail de montage normalisé prévu sur un châssis de câblage électrique et le capot (22) comportant des trous de fixation (28) agencés pour permettre le montage dudit compteur sur une porte d'armoire électrique.

9. Compteur d'énergie selon l'une quelconque des revendications précédentes, comportant un nombre de bornes d'entrée (3) et de sortie (4), de tunnels (70), de transformateurs d'intensité (8) et de prises de tension (9) égal au nombre de phases dudit réseau de distribution, **caractérisé en ce que** les transformateurs d'intensité (8) sont disposés en quinconce et **en ce que** les circuits électroniques (10) sont répartis sur deux plaques de circuit imprimé parallèles (11, 12) montées de part et d'autre des tunnels (70) pour former un module compact.

10. Compteur d'énergie selon la revendication 9, **caractérisé en ce que** les plaques des circuits imprimés (11, 12) comportent en regard des transformateurs d'intensité (8) des découpes correspondantes laissant traverser partiellement lesdits transformateurs

## Patentansprüche

1. Stromzähler (1), der ein Gehäuse (2) mit mindestens einer ausgerichteten Einführungsklemme (3) und einer Durchführungsklemme (4) aufweist, die zur Aufnahme einer Anschlussschnur (5,5') eines Leitungsnetzes in der Lage sind, wobei jede Klemme (3,4) mit einem Klemmbauteil (31) für das Kabel versehen ist, wobei das Gehäuse (2) angeordnet ist, um einen sich zwischen den zwei Klemmen erstreckenden geradlinigen Kabeldurchgang (7) festzulegen, wobei der Stromzähler auch einen rund um den Kabeldurchgang (7) angeordneten Stromwandler (8) aufweist, wobei ein Spannungsabgriff (9) auf einer der Klemmen vorgesehen, und ein mit dem Stromwandler und dem Spannungsabgriff verbundener elektronischer Schaltkreis (10) angeordnet ist, um die von denselben gemessenen Informationen zu verarbeiten, wobei der Stromzähler einen sich zwischen den zwei Klemmen erstreckenden, elektrisch isolierten Tunnel (70) aufweist, der den geradlinigen Kabeldurchgang (7) ausbildet, **dadurch gekennzeichnet, dass** die Einführungs- (3) und Durchführungsklemmen (4) in mindestens einer ihrer Wände eine dem Klemmbauteil (31) gegenüberliegende Aussparung (35) aufweisen, und dass der Zähler ein elektrisch leitendes Teil (6) aufweist, welches dauerhaft im Inneren des Tunnels (70) angeordnet ist und sich zwischen den Einführungs- (3) und Durchfiihrungsklemmen (4) erstreckt, um sie elektrisch zu verbinden, wobei eine Überbrückung ausgebildet wird, wobei das leitende Teil (6) aus einer metallischen Lamelle mit geringer Dicke ausgebildet ist und einen Querschnitt aufweist, der denjenigen der in den Klemmen vorgesehenen Aussparung (35) ergänzt.

2. Stromzähler nach Anspruch 1, **dadurch gekennzeichnet, dass** der Tunnel (70) aus zwei koaxial eingepassten Halbtunneln (71,72) besteht, die so angeordnet sind, dass sie einen ununterbrochenen und geradlinigen Kabeldurchgang (7) ausbilden, wobei die Halbtunnel einen dem Innendurchmesser des Stromwandlers (8) entsprechenden Außendurchmesser aufweisen.

3. Stromzähler nach Anspruch 1, **dadurch gekennzeichnet, dass** die Einführungs- (3) und Durchführungsklemmen (4) einen koaxial zu dem Tunnel (70) angeordneten, inneren metallischen Flansch (30) aufweisen, wovon mindestens eine Wand die Aussparung (35) aufweist, wobei der innere Flansch (30) in einem aus den zwei eingepassten Teilen (41,42) ausgebildeten Klemmenkörper (40) gelagert ist.

4. Stromzähler nach Anspruch 3, **dadurch gekennzeichnet, dass** das Klemmbauteil eine Klemmschraube (31), die in dem inneren Flansch (30) senkrecht zu der Achse des Kabeldurchgangs (7) angebracht ist, und eine Klammer (33) aufweist, die zwischen dem äußersten Ende der Klemmschraube (31) und der in der Klemme (3,4) gelagerten elektrischen Anschlussschnur (5,5') positioniert ist.

5. Stromzähler nach Anspruch 3, **dadurch gekennzeichnet, dass** der Spannungsabgriff (9) eine in dem inneren Flansch (30) senkrecht zu der Achse des Kabeldurchgangs (7) angebrachte Stellschraube (9) umfasst, die angeordnet ist, um nach ihrem Festklemmen einen elektrischen Kontakt mit der in der Klemme (3,4) gelagerten Anschlussschnur (5,5') herzustellen.

6. Stromzähler nach Anspruch 1, **dadurch gekennzeichnet, dass** der elektronische Schaltkreis (10) mindestens eine gedruckte Schaltung (11,12) aufweist, die mittels außerhalb des Tunnels vorgesehener Befestigungslaschen (76) direkt auf dem Tunnel (70) befestigt ist.

7. Stromzähler nach Anspruch 6, **dadurch gekennzeichnet, dass** die gedruckte Schaltung (11,12) angeordnet ist, um einen die galvanische Isolation sicherstellenden Stromwandler (13) aufzunehmen.

8. Stromzähler nach Anspruch 1, **dadurch gekennzeichnet, dass** das Gehäuse (2) mehrere durch Einpassen montierte Teile, d. h. mindestens einen Sockel (20) und eine Abdeckhaube (22) umfasst, wobei der Sockel (20) eine Nut (21) aufweist, die angeordnet ist, um eine auf einem Rahmen für elektrische Verdrahtung vorgesehene standardisierte Montageschiene aufzunehmen, und wobei die Abdeckhaube (22) Befestigungsbohrungen (28) aufweist, die angeordnet sind, um die Montage des Zählers auf einer Schaltschranktür zu ermöglichen.

9. Stromzähler nach einem der vorangegangenen Ansprüche, der eine Anzahl von Einführungs- (3) und Durchführungsklemmen (4), von Tunneln (70), von Stromwandlern (8) und von Spannungsabgriffen (9) aufweist, die der Anzahl von Phasen des Leitungsnetzes entspricht, **dadurch gekennzeichnet, dass** die Stromwandler (8) zickzackförmig versetzt angeordnet sind, und dass die elektronischen Schaltkreise (10) auf zwei parallel verlaufenden Platten von gedruckten Schaltungen (11,12) verteilt sind, die beiderseits des Tunnels (70) so angebracht sind, dass sie ein kompaktes Modul ausbilden.

10. Stromzähler nach Anspruch 9, **dadurch gekennzeichnet, dass** die Platten der gedruckten Schaltungen (11,12) den Stromwandlern (8) gegenüberliegend Ausschnitte aufweisen, die den Wandlern ein teilweises Durchqueren ermöglichen.

## Claims

1. An electrical energy meter (1) comprising a housing (2), at least one input terminal (3) and one output terminal (4), which are aligned and able to receive an electric cable (5, 5') of a distribution network, each terminal (3, 4) being provided with a clamping member (31) for the said cable, the said housing (2) being designed to define a rectilinear raceway (7) extending between the two terminals, this energy meter also comprising a current transformer (8) disposed around the said raceway (7), a voltage tap (9) provided on one of the said terminals and an electronic circuit (10) connected to the said current transformer and to the said voltage tap to process the information which they measure, the said energy meter comprising an electrically insulated tunnel (70) extending between the two terminals and forming the said rectilinear raceway (7), **characterised in that** the input (3) and output terminals (4) have in at least one of their walls a recess (35) opposite the clamping member (31) and **in that** this meter comprises an electrically conductive part (6) disposed permanently inside the said tunnel (70) and extending between the input (3) and output terminals (4) to connect them electrically forming a bridging, the said conductive part (6) being formed from a metallic blade which is not very thick and has a section complementary to that of the said recess (35) provided in the said terminals.

2. An energy meter according to Claim 1, **characterised in that** the tunnel (70) is formed by two half-tunnels (71, 72) which are coaxially nested and designed to form a continuous, rectilinear raceway (7), these half-tunnels having an external diameter corresponding to the internal diameter of the said current transformer (8).

3. An energy meter according to Claim 1, **characterised in that** the input (3) and output terminals (4) comprise an inner metallic flange (30), disposed coaxially to the said tunnel (70) and at least one wall of which comprises the said recess (35), this inner flange (30) being housed in a terminal body (40) formed of two nested parts (41, 42).

4. An energy meter according to Claim 3, **characterised in that** the clamping member comprises a clamping screw (31) mounted in the inner flange (30) perpendicularly to the axis of the raceway (7) and a flat jumper (33) interposed between the end of the clamping screw (31) and the electric cable (5, 5') housed in the said terminal (3, 4).

5. An energy meter according to Claim 3, **characterised in that** the voltage tap comprises a cone-point set screw (9) mounted in the inner flange (30) perpendicularly to the axis of the raceway (7) and designed to create an electrical contact with the said electric cable (5, 5') housed in the said terminal (3, 4) after its clamping.

6. An energy meter according to Claim 1, **characterised in that** the electronic circuit (10) comprises at least one printed circuit (11, 12) fixed directly onto the said tunnel (70) by means of lugs (76) provided on the outside of the said tunnel.

7. An energy meter according to Claim 6, **characterised in that** the said printed circuit (11, 12) is designed to receive a voltage transformer (13) ensuring electrical separation.

8. An energy meter according to Claim 1, **characterised in that** the housing (2) comprises several parts assembled by nesting, including at least a base (20) and a cover (22), the base (20) comprising a groove (21) designed to receive a standardised mounting rail provided on a electrical wiring frame and the cover (22) comprising mounting holes (28) designed to allow the mounting of the said meter on a switch cabinet door.

9. An energy meter according to any one of the preceding Claims, comprising a number of input (3) and output terminals (4), tunnels (70), current transformers (8) and voltage taps (9) equal to the number of phases of the said distribution network, **characterised in that** the current transformers (8) have a staggered arrangement and **in that** the electronic circuits (10) are distributed over two parallel printed circuit boards (11, 12) mounted on either side of the tunnels (70) to form a compact module.

10. An energy meter according to Claim 9, **characterised in that** the printed circuit boards (11, 12) comprise, opposite the current transformers (8), corresponding cut-outs which allow the said transformers partially to pass.
